# FASCICULE DE BREVET EUROPEEN

(11) **EP 1 647 990 B1**
(45) Date de publication et mention de la délivrance du brevet: **24.12.2008**
(21) Numéro de dépôt: 04290128.0
(22) Date de dépôt: 19.01.2004
(51) Int. Cl.: G11C 11/406, G11C 29/00

(54) **Procédé de rafraîchissement d'une mémoire vive dynamique, et dispositif de mémoire vive dynamique correspondant, en particulier incorporé dans un téléphone mobile cellulaire**
Verfahren zum Auffrischen eines DRAM und dazugehörige DRAM-Vorrichtung, insbesondere in ein zellulares Mobiltelefon eingebaut
Method for refreshing a dynamic RAM, and corresponding dynamic RAM device, in particular incorporated in a cellular mobile telephone

(30) Priorité: 29.01.2003 FR 0301005
(43) Date de publication de la demande: 19.04.2006
(73) Titulaire: STMicroelectronics SA, 92120 Montrouge (FR)
(72) Inventeur: Harrand, Michel, 38120 Saint-Egreve (FR); Bulone, Joseph, 38530 La Buissière (FR)
(74) Mandataire: Zapalowicz, Francis

(56) Documents cités:
- WO-A-91/07756
- DE-A1- 10 304 673
- US-A- 5 629 898
- US-A- 6 141 280
- US-A1- 2002 080 674
- US-A1- 2002 136 075
- US-B1- 6 199 139
- US-B1- 6 229 747
- US-B1- 6 256 703
- US-B1- 6 272 588
- INTERNATIONAL BUSINESS MACHINES CORPORATION: "Method and apparatus for maximizing availability of an embedded dynamic memory cache" RESEARCH DISCLOSURE, KENNETH MASON PUBLICATIONS, HAMPSHIRE, GB, vol. 444, no. 143, avril 2001 (2001-04), XP007128041 ISSN: 0374-4353
- PATENT ABSTRACTS OF JAPAN vol. 2003, no. 03, 5 mai 2003 (2003-05-05) & JP 2002 324397 A (MITSUBISHI ELECTRIC CORP), 8 novembre 2002 (2002-11-08)

## Description

L'invention concerne les mémoires vives dynamiques, c'est-à-dire nécessitant un rafraîchissement périodique des données que contiennent les cellules-mémoire de ces mémoires. Et, l'invention concerne plus particulièrement le rafraîchissement de ces mémoires vives dynamiques.

L'invention s'applique avantageusement, mais non limitativement, aux téléphones mobiles cellulaires qui incorporent des mémoires vives dynamiques.

Les téléphones mobiles cellulaires de troisième génération vont nécessiter l'intégration de grandes quantités de mémoire. Cependant, le coût du produit doit rester faible. L'utilisation de mémoires vives dynamiques (DRAM) à la place des mémoires vives statiques (SRAM) utilisées aujourd'hui, permet cet accroissement de capacité de mémoire pour un faible coût.

Cependant, une contrainte importante dans ce type d'application, est la faible consommation électrique pendant que le téléphone est en veille, afin de ne pas décharger les batteries trop vite. Or, si les mémoires vives dynamiques ont un courant de fuite statique plus faible que les mémoires vives statiques, elles nécessitent en revanche d'être continuellement rafraîchies si l'on doit conserver les données en mode veille. Et, ce rafraîchissement nécessite une consommation d'énergie qu'il importe de minimiser.

La fréquence de rafraîchissement est donnée par le nombre de pages-mémoire à rafraîchir et par le temps de rétention de la mémoire. Ce temps de rétention est essentiellement lié aux fuites de jonction des transistors des cellules-mémoire. Or, ces fuites varient essentiellement en fonction de la température.

Actuellement, on rafraîchit les mémoires vives dynamiques à la fréquence correspondant au pire cas de fonctionnement, c'est-à-dire à la température maximum de l'application.

On connaît par l'article de Jae-Yoon Sim et autres, intitulé "Double Boosting Pump, Hybrid Current Sense Amplifier, and Binary Weighted Temperature Sensor Adjustment Schemes for 1,8 V 128 Mb Mobile DRAMs", 2002 Symposium on VLSI Circuits Digest of Technical Papers, un système de mesure de la température intégré sur la puce supportant la mémoire vive dynamique, et qui agit sur la fréquence de rafraîchissement. Cependant, ce système nécessite un ajustage du capteur de température au niveau du test sur plaquette, ce qui peut compliquer ce test, et donc le rendre plus cher. En outre, le capteur de température consomme lui-même un peu de courant.

Le document intitulé « method and apparatus for maximizing availability of an embedded dynamic memory cache", International Business Machines Corporation, ISSN 0374-4353 volume 444, n° 143 décrit une méthode et un système pour augmenter la capacité d'une mémoire tampon dynamique embarquée en étendant la période de rafraîchissement tout en maintenant l'intégrité des données en évitant une perte de données due à une période excessive entre les rafraîchissements. A cet égard, on procède à une détection des erreurs et on utilise un circuit de correction de façon à contrôler le seuil de perte de données dû à un rafraîchissement inadéquat.

Le document US 6,199,139 propose un système pouvant optimiser la période de rafraîchissement d'une mémoire pendant l'état de veille. L'évaluation de la période de rafraîchissement est réalisée à chaque période de rafraîchissement.

Le document WO 91/07756 décrit une méthode de rafraîchissement de mémoire dont l'ajustement de la période de rafraîchissement est dépendant de la réponse d'un capteur de température.

L'invention vise à optimiser la fréquence de rafraîchissement d'une mémoire vive dynamique, et ce de façon particulièrement simple à mettre en oeuvre et sans utiliser de capteur externe.

Selon un aspect, l'invention propose donc un procécé de rafraîchissement de mémoire vive dynamique dans lequel on mesure continuellement et dynamiquement le temps de rétention de toutes les cellules mémoire de la mémoire et l'on utilise le résultat de cette mesure pour réguler la période de rafraîchissement de la mémoire.

Une utilisation de toutes les cellules-mémoire de la mémoire permet d'ajuster la période de rafraîchissement de la mémoire en utilisant le temps de rétention réel de toute la mémoire, et non en utilisant des caractérisations statistiques du rapport entre temps de rétention moyen des cellules et temps de rétention minimum sur la mémoire, et également sans utilisation de tout autre moyen externe, tel qu'un capteur de température.

Selon une caractéristique générale de cet aspect de l'invention, la mesure continuelle et dynamique du temps de rétention de toutes les cellules comporte :
- des sélections successives de groupes différents de cellules de la mémoire, dites cellules de test, de façon à balayer l'ensemble des cellules de la mémoire,
- des mesures élémentaires successives des temps de rétention de chaque groupe de cellules de test sélectionnées, et
- des rafraîchissements successifs des cellules non sélectionnées.

Par ailleurs, lesdites mesures élémentaires successives sont effectuées à une fréquence de mesure plus faible que la fréquence de rafraîchissement des autres cellules de la mémoire, de façon à « rafraîchir » les groupes de cellules de test plus lentement que les autres cellules de la mémoire.

Lorsque la mémoire est organisée par pages, chaque groupe de cellules de test est de préférence un nombre entier de pages, par exemple une page ou plusieurs pages.

Une façon particulièrement simple d'effectuer la phase de mesure élémentaire du temps de rétention d'un groupe de cellules de test sélectionnées peut comporter :
- une écriture dans ces cellules de test sélectionnées d'un contenu de test prédéterminé correspondant au chargement de tous les condensateurs des cellules de test,
- puis une lecture des cellules de test et une comptabilisation du nombre d'erreurs en lecture du contenu des cellules de test compte-tenu dudit contenu de test.

Par ailleurs, la mesure du temps de rétention de toutes les cellules comporte par exemple une accumulation au moins partielle des nombres successifs d'erreurs.

Enfin, entre l'écriture du contenu de test dans les cellules de test et la lecture de ces cellules de test, on effectue au moins deux rafraîchissements des autres cellules de la mémoire.

En général, la régulation de la période de rafraîchissement s'effectue à la fin du test de l'ensemble des cellules de la mémoire. Cependant, il est également possible, et c'est la raison pour laquelle on parle d'accumulation au moins partielle, que la régulation de la période de rafraîchissement puisse s'effectuer dès qu'un certain nombre d'erreurs a été détecté, sans attendre la fin du test de l'ensemble de la mémoire, notamment si l'on veut pouvoir réagir plus rapidement à une variation de température.

Lorsque des pages de la mémoire ne contiennent pas de données utiles et sont utilisées comme pages de test, il n'y a pas lieu d'en sauvegarder le contenu. Par contre, lorsque des pages mémoire contiennent des données utiles et sont à leur tour sélectionnées comme cellules de test, il faut sauvegarder leur contenu.

C'est la raison pour laquelle la phase de mesure élémentaire comporte en outre pour certains au moins des groupes de cellules de test sélectionnées, une sauvegarde du contenu de ces cellules de test, et une restauration du contenu cellules de test avec le contenu sauvegardé une fois la comptabilisation du nombre d'erreurs effectuée.

On peut effectuer la sauvegarde dans une partie prédéterminée de la mémoire, par exemple dans des pages ne contenant pas de données utiles, ou bien si l'on ne souhaite pas mettre de contrainte sur l'utilisation de certaines pages de la mémoire, dans une mémoire de sauvegarde externe. Bien entendu, dans ce cas, cette mémoire externe devra contenir au moins autant de pages que l'on en teste en un cycle de mesure du temps de rétention.

Lorsqu'il est prévu deux mémoires-tampon connectées à la mémoire dynamique, la phase de mesure élémentaire comporte avantageusement une écriture du contenu de test dans une première mémoire tampon avant écriture dans les cellules de test. Par ailleurs, la lecture du contenu des cellules de test comporte une écriture du contenu de ces cellules de test dans la deuxième mémoire-tampon puis une lecture de la deuxième mémoire tampon.

Ceci permet de diminuer encore la consommation de courant. En effet, le rechargement périodique du contenu de test se fait alors en une seule opération de la mémoire-tampon dans la page de test, au lieu de devoir réécrire systématiquement tous les mots de la page-mémoire.

Par ailleurs, lorsque l'on n'utilise qu'une seule page-mémoire comme page de test, on peut avantageusement utiliser l'une des mémoires tampons comme mémoire de sauvegarde externe.

Ainsi, selon un mode de mise en oeuvre de l'invention, on sauvegarde le contenu de quelques pages de la mémoire vive dynamique, puis on essaie de les rafraîchir moins vite, par exemple deux fois moins vite, et l'on observe si cela provoque des erreurs ou non. On répète l'opération sur toute la mémoire. Suivant le nombre d'erreurs apparues sur les pages rafraîchies moins souvent, on diminue ou on augmente la période de rafraîchissement. Ainsi, la mémoire auto-ajuste sa période de rafraîchissement à ce qui lui est nécessaire.

Le nombre de pages de test est par exemple choisi de manière à ce que le temps nécessaire pour tester la rétention de toutes les pages de la mémoire soit suffisamment faible devant les temps de changements de température du système. Ainsi, à titre indicatif, si l'on considère une mémoire comprenant 4096 pages de rétention minimum égale à 32 ms, et que l'on souhaite gagner, à température typique, un facteur 4 sur la consommation due au rafraîchissement à la température minimum, donc avoir une période de rafraîchissement maximum de 4 x 32 ms, et si l'on suppose également que l'on rafraîchit la mémoire deux fois plus souvent que les pages de test, il faut donc 256 ms (2 x 4 x 32) par jeu de pages de test. De manière à ce que la période de rafraîchissement soit évaluée toutes les minutes, il faut par conséquent utiliser 16 pages de test environ (4096/(60s/256ms)).

En ce qui concerne la régulation de la période de rafraîchissement, plusieurs solutions sont possibles.

Selon une première possibilité, la régulation de la période de rafraîchissement de la mémoire peut comporter
- une comparaison du nombre d'erreurs accumulées, avec un seuil bas et un seuil haut,
- une augmentation de la période de rafraîchissement si le nombre d'erreurs est inférieur au seuil bas,
- une diminution de la période de rafraîchissement si le nombre d'erreurs est supérieur au seuil haut, et
- une non-modification de la période de rafraîchissement si le nombre d'erreurs est supérieur ou égal au seuil bas et inférieur ou égal au seuil haut.

Une autre solution, plus simple, pour la régulation de la période de rafraîchissement de la mémoire, peut consister à comparer le nombre d'erreurs accumulées avec un seuil unique, et à augmenter la période de rafraîchissement si le nombre d'erreurs est inférieur ou égal au seuil unique, et à diminuer la période de rafraîchissement si le nombre d'erreurs est supérieur ou égal au seuil unique.

Il est par ailleurs préférable de prévoir une valeur limite minimale et, plus particulièrement, une valeur limite maximale pour la période de rafraîchissement. En effet, il vaut mieux tester la rétention des cellules à un rythme qui reste rapide devant celui de l'évolution de la température.

Bien que le procédé selon l'invention puisse être appliqué à tout moment, il est plus particulièrement destiné à être appliqué pendant un mode de veille. Ainsi, lorsque la mémoire est incorporée dans un appareil possédant un mode de veille et un mode de fonctionnement actif, comme par exemple un téléphone mobile cellulaire, on mesure avantageusement le temps de rétention moyen des cellules de test et on régule la période de rafraîchissement, au moins au cours du mode de veille.

L'invention permet également notamment de réduire la fréquence de rafraîchissement, donc la consommation en mode veille, même à la température maximum de fonctionnement.

Le principe d'un tel mode de mise en oeuvre est de repérer les pages ayant la moins grande rétention, de les noter, et de les rafraîchir plus souvent que les autres. En effet, généralement, plus de 90 % des pages de la mémoire peuvent être rafraîchies deux à quatre fois moins souvent que ne le nécessitent les cellules ayant une rétention minimum.

En d'autres termes, la mesure du temps de rétention de toutes les cellules de la mémoire étant effectuée cycliquement, il est prévu, selon un mode de réalisation de l'invention, qu'au cours d'un cycle de mesure, par exemple le premier, on repère les cellules de la mémoire ayant une rétention plus faible. Puis, au cours du ou des cycles suivants, on rafraîchit ces cellules dites "faibles" plus souvent que les autres cellules de la mémoire.

Le repérage des cellules « faibles » peut également être effectué régulièrement au cours d'un cycle courant de régulation de la période de rafraîchissement de la mémoire.

Selon un autre aspect, l''invention propose également un dispositif de mémoire vive dynamique, comprenant une mémoire vive dynamique, des moyens de rafraîchissement de la mémoire, et des moyens auxiliaires de traitement aptes à mesurer continuellement et dynamiquement le temps de rétention de toutes les cellules-mémoire de la mémoire, et à utiliser le résultat de cette mesure pour réguler la période de rafraîchissement de la mémoire.

Selon une caractéristique générale de cet aspect de l'invention, les moyens auxiliaires de traitement comportent
- des moyens de sélection aptes à effectuer des sélections successives de groupes différents de cellules de la mémoire, dites cellules de test, de façon à balayer l'ensemble des cellules de la mémoire, et
- des moyens de mesure aptes à effectuer des mesures élémentaires successives des temps de rétention de chaque groupe de cellules de test sélectionnées.

Par ailleurs les moyens de rafraîchissement sont aptes à effectuer des rafraîchissements successifs des cellules non sélectionnées, et les moyens auxiliaires de traitement comportent des moyens de commande aptes à activer les moyens de mesure moins souvent que les moyens de rafraîchissement, de façon à « rafraîchir » les groupes de cellules de test plus lentement que les autres cellules de la mémoire.

Selon un mode de réalisation de l'invention, les moyens de mesure comportent
- des moyens de stockage aptes à stocker un contenu de test prédéterminé correspondant au chargement de tous les condensateurs des cellules de test,
- des moyens d'écriture aptes à écrire le contenu de test dans les cellules de test sélectionnées,
- des moyens de lecture aptes à lire le contenu des cellules de test,
- des moyens de comptabilisation aptes à comptabiliser le nombre d'erreurs en lecture du contenu des cellules de test compte tenu dudit contenu de test,
- des moyens d'accumulation aptes à effectuer une accumulation au moins partielle des nombres successifs d'erreurs.

Et entre l'écriture du contenu de test dans les cellules de test et la lecture de ces cellules de test, les moyens de commande sont aptes à activer les moyens de rafraîchissement au moins deux fois.

Selon un mode de réalisation de l'invention, les moyens de mesure comportent en outre des moyens de sauvegarde aptes à effectuer une sauvegarde du contenu des cellules de test, et des moyens de restauration aptes à effectuer une restauration du contenu des cellules de test avec le contenu sauvegardé une fois la comptabilisation du nombre d'erreurs effectuées. Et les moyens de commande sont aptes à activer les moyens de sauvegarde et de restauration pour certains au moins des groupes de cellules de test sélectionnées.

Selon un mode de réalisation de l'invention, les moyens auxiliaires de traitement sont aptes à effectuer cycliquement la mesure du temps de rétention de toutes les cellules de la mémoire. Au cours d'un cycle de mesure, les moyens auxiliaires de traitement sont aptes à repérer les cellules de la mémoire ayant une rétention plus faible, et au cours du ou des cycles suivants les moyens de rafraîchissement sont aptes à rafraîchir ces cellules dites faibles plus souvent que les autres cellules de la mémoire.

Le dispositif selon l'invention est avantageusement réalisé sous la forme d'un circuit intégré.

L'invention vise également un appareil possédant un mode de veille et un mode de fonctionnement actif et incorporant un dispositif tel que défini ci-avant, les moyens auxiliaires de traitement étant aptes à mesurer le temps de rétention de toutes les cellules de la mémoire et à réguler la période de rafraîchissement, au moins au cours du mode de veille.

Cet appareil peut être un composant d'un système de communication sans fil, par exemple un téléphone mobile cellulaire.

D'autres avantages et caractéristiques de l'invention apparaîtront à l'examen de la description détaillée de modes de mise en oeuvre et de réalisation, nullement limitative, et des dessins annexés sur lesquels :
- la figure 1 illustre très schématiquement une mémoire vive selon l'invention au sein de laquelle les cellules de test sont successivement regroupées en lignes,
- la figure 2 illustre plus en détail mais toujours schématiquement un dispositif de mémoire selon l'invention et plus particulièrement les moyens auxiliaires de traitement associés à la mémoire vive selon l'invention,
- la figure 3 représente un organigramme schématique d'un mode de mise en oeuvre du procédé selon l'invention, et,
- la figure 4 illustre un autre mode de mise en oeuvre de l'invention.

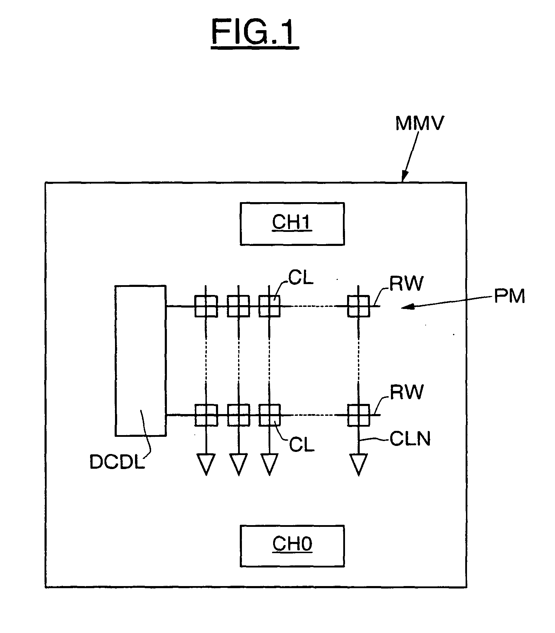

Sur la figure 1, la référence MMV désigne une mémoire vive dynamique selon l'invention dont le plan mémoire PM comporte un réseau matriciel de cellules-mémoire CL typiquement organisé en rangées (lignes) RW et en colonnes CLN. Chaque cellule-mémoire comporte généralement un transistor et un condensateur.

Par ailleurs, de façon classique et connue en soi, le plan mémoire est connecté à un décodeur ligne DCDL et à un décodeur-colonne (non représentés ici à des fins de simplification).

Enfin, dans l'exemple décrit ici, la mémoire MMV comporte deux mémoires-tampons CH0 et CH1 connectées au plan mémoire PM.

L'architecture d'une telle mémoire équipée de deux mémoires-tampons est par exemple décrite dans la demande de brevet européen publiée sous EP 0 952 587, et va permettre, comme on le verra plus en détail ci-après, une mise en oeuvre préférée de l'invention.

D'une façon générale, selon l'invention, on va mesurer continuellement et dynamiquement sur la puce (circuit intégré) contenant la mémoire MMV, le temps de rétention de toutes les cellules de la mémoire, et on va ajuster la période de rafraîchissement de cette mémoire en conséquence.

Dans l'exemple décrit ici, la mémoire est organisée en pages-mémoire, une page correspondant à une ligne de mots.

Et, avant de revenir plus en détail sur l'algorithme d'ajustement de la période de rafraîchissement, on peut d'ores et déjà en décrire les grandes ligne d'un mode de mise en oeuvre.

Plus précisément, on sauvegarde le contenu d'une ou de plusieurs pages de cette mémoire, que l'on qualifie alors de page(s) de test, puis on essaie de les rafraîchir moins vite, par exemple deux fois moins vite que les pages restantes. On observe si cela provoque des erreurs ou non.

On répète l'opération sur toute la mémoire en changeant à chaque fois de page de test. Suivant le nombre d'erreurs apparues sur les pages rafraîchies moins souvent, on diminue ou on augmente la période de rafraîchissement.

Ainsi, la mémoire auto-ajuste sa période de rafraîchissement à ce qui lui est nécessaire.

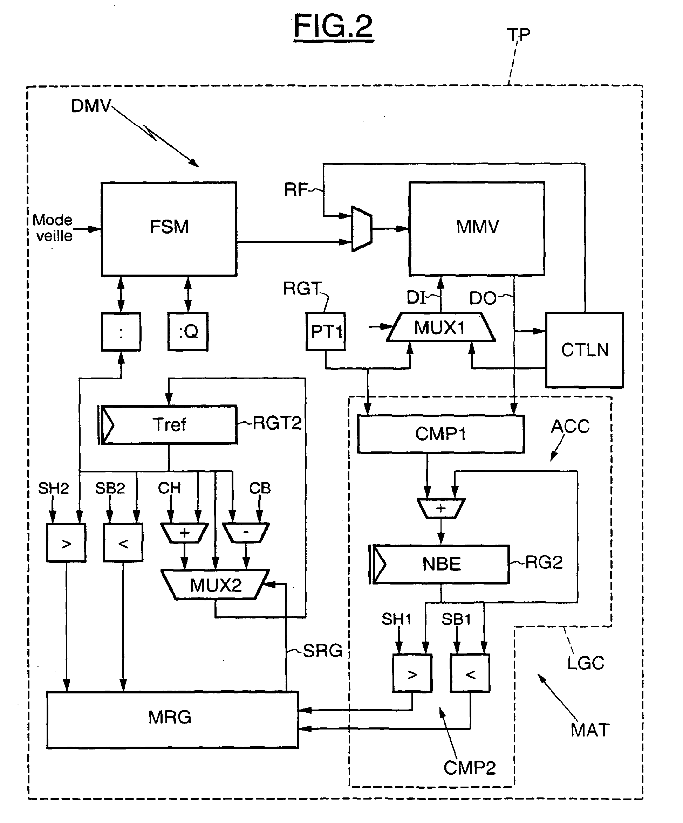

Afin de mettre en oeuvre le mécanisme de régulation de la fréquence de rafraîchissement de la mémoire vive MMV, le dispositif de mémoire DMV selon l'invention comporte (figure 2) outre la mémoire MMV, des moyens auxiliaires de traitement MAT dont on va maintenant décrire plus en détail la structure et les fonctionnalités. Dans une application particulière de l'invention, ce dispositif est incorporé dans un téléphone mobile cellulaire TP.

Les moyens auxiliaires de traitement MAT comportent des moyens de stockage RGT formés ici d'un registre, et contenant un contenu de test prédéterminé PT1 correspondant au chargement de tous les condensateurs des cellules courantes de test. Plus précisément, ce contenu de test PT1 comporte des valeurs logiques qui sont choisies de façon à ce que lorsqu'elles sont écrites dans les cellules-mémoire, les condensateurs correspondants de ces cellules-mémoire soient chargés à la tension qui correspond au pire cas de rétention. Dans le cas présent cette tension est égale à la tension d'alimentation. Ceci étant, dans d'autres types de mémoire, par exemple à base de transistors PMOS, cette tension peut être la masse. Par ailleurs, les valeurs de ces bits de test dépendent de la façon dont est réalisée la mémoire (colonne paire, colonne impaire...).

Le contenu de test PT1 peut être délivré sur le bus de données d'entrée DI de la mémoire par l'intermédiaire d'un multiplexeur MUX1 commandé par un signal de commande.

L'autre entrée du multiplexeur MUX1 reçoit les données utiles à écrire dans la mémoire et émanant d'un contrôleur classique CTLN dédié au mode de fonctionnement normal de la mémoire.

Ce contrôleur CTLN est par ailleurs connecté sur le bus de données de sortie DO de la mémoire.

Enfin, il émet un signal RF comportant les commandes de rafraîchissement ainsi que les signaux de contrôle et d'adresses de la mémoire. Ainsi, toutes les cellules de la mémoire sont périodiquement rafraîchies, la période entre deux cycles de rafraîchissement de page étant désignée ici par Tref.

Des moyens de comparaison CMP1 reçoivent d'une part le contenu du registre RGT, c'est-à-dire le contenu de test PT1, et d'autre part, le contenu des cellules de test, par l'intermédiaire du bus de sortie DO.

Les moyens de comparaison CMP1 vont comparer à des instants prédéterminés, le contenu des cellules courantes de test avec le contenu de test PT1. Ces moyens de comparaison CMP1 vont, en combinaison avec des moyens d'accumulation ACC, permettre de comptabiliser le nombre d'erreurs en lecture des cellules courantes de test et d'accumuler également les nombres d'erreurs des pages successives de test lors du balayage complet de la mémoire MMV. Ce nombre d'erreurs NBE est stocké dans un registre RG2.

La structure utilisée dans ce mode de réalisation pour comptabiliser le nombre d'erreurs NBE est compatible avec une lecture d'une ligne de mots par blocs de bits. Plus précisément, par exemple, lorsqu'une ligne de mots contient 1024 bits, les 1024 bits sont lus par blocs de 64 bits, ce qui nécessite 16 accès à la mémoire.

Plusieurs modes de réalisation sont alors possibles pour effectuer la régulation de la période de rafraîchissement à partir de la connaissance du nombre NBE.

L'un de ces modes de réalisation est celui illustré sur le reste de la figure 2 et que l'on va maintenant décrire.

Le nombre d'erreurs NBE est comparé, dans des moyens de comparaison CMP2, à un seuil haut SH1 et à un seuil bas SB1. Les valeurs des seuils haut et bas, SH1 et SB1, seront déterminées par l'homme du métier en fonction par exemple de l'application envisagée et du type de mémoire utilisée.

La sortie des moyens de comparaison CMP2 est reliée à l'entrée d'une logique de décision MRG qui fait office de moyens de régulation de la période de rafraîchissement Tref.

Plus précisément, d'une façon générale, si le nombre d'erreurs NBE est inférieur au seuil bas SB1, on augmente la période de rafraîchissement Tref. Si ce nombre d'erreurs est supérieur au seuil haut SH1, on diminue cette période. S'il est inférieur ou égal au seuil haut et supérieur ou égal au seuil bas, on laisse la période de rafraîchissement Tref inchangée.

Matériellement, ceci peut être réalisé par un multiplexeur MUX2 commandé par le signal de régulation SRG émanant des moyens MRG. Ce multiplexeur MUX2 possède trois entrées. L'entrée médiane est reliée à la sortie du registre RGT2 qui contient la valeur de la période de rafraîchissement Tref.

Une autre entrée du multiplexeur est reliée à la sortie d'un additionneur. Un tel additionneur possède une première entrée reliée à la sortie du registre RGT2 et une deuxième entrée reliée à une constante CH.

Le multiplexeur MUX2 possède également une troisième entrée reliée à la sortie d'un soustracteur. Ce soustracteur possède une première entrée reliée à la sortie du registre RGT2 et une deuxième entrée reliée à une constante CB.

La sortie du multiplexeur MUX2 et reliée à l'entrée du registre RGT2.

Ainsi, si la période de rafraîchissement doit rester inchangée, c'est l'entrée médiane du multiplexeur MUX2 qui est sélectionnée.

Par contre, si la période de rafraîchissement doit être augmentée, c'est l'entrée de gauche (sur la figure 2) qui est choisie, la période de rafraîchissement étant alors incrémentée de la constante CH.

Si la période de rafraîchissement doit être diminuée, c'est l'entrée de droite du multiplexeur MUX2 qui est sélectionnée, la période de rafraîchissement étant alors diminuée de la constante CB.

Ceci étant, il est également prévu deux autres registres comportant respectivement une valeur limite inférieure SB2 et une valeur limite SH2 pour la période de rafraîchissement Tref.

Et, la régulation de la période de rafraîchissement qui vient d'être décrite, s'applique tant que la période de rafraîchissement se situe entre ces deux valeurs limites SB2 et SH2. Par contre, si la période de rafraîchissement est inférieure à la valeur limite SB2, la régulation de la période de rafraîchissement ne peut se traduire que par une augmentation de la période de rafraîchissement. De même si la période de rafraîchissement est supérieure à la valeur limite SH2, alors la régulation de la période de rafraîchissement ne peut se traduire que par une diminution de la période de rafraîchissement.

En pratique, à l'initialisation, on choisira une période de rafraîchissement correspondant à la fréquence maximum de rafraîchissement compte tenu du pire cas de température. Cette valeur initiale de la période correspond alors à la valeur limite minimale SB2. A titre indicatif, pour une température de 85 °C, le temps de rétention pire cas correspond à 32 ms.

En variante, il est également possible d'utiliser un algorithme de décision de modification de la période de rafraîchissement très simple, n'utilisant qu'un seul seuil pour la comparaison du nombre d'erreurs NBE, par exemple un seuil égal à zéro.

Plus précisément, s'il n'y a aucune erreur dans toute la mémoire, on augmente la valeur de la période de rafraîchissement (cette nouvelle valeur devant être inférieure au double de la valeur précédente dans le cas où on "rafraîchit" les pages de test deux fois moins vite que le reste de la mémoire), sinon on la diminue, avec comme dans la variante qui vient d'être décrite, une valeur limite inférieure SB2 et une valeur limite supérieure SH2.

Dans ce cas, la logique de comptage du nombre d'erreurs NBE, rectangle LGC matérialisé en tiretés sur la figure 2, se ramène à une simple porte logique OU sur les bits d'erreurs, et à une bascule unique, mise à 1 si une erreur au moins est détectée, et remise à zéro par la machine d'état FSM à chaque cycle principal de l'algorithme (c'est-à-dire lorsque les pages de test redeviennent celles utilisées au début du cycle).

Ainsi qu'on vient de l'évoquer, outre les moyens qui viennent d'être décrits, les moyens auxiliaires de traitement MAT comportent également des moyens de commande, sous la forme d'une machine à états finis FSM. Et, c'est cette machine FSM qui va séquencer le "rafraîchissement" des cellules de test et déclencher le calcul du nombre d'erreurs NBE ainsi que la régulation de la période de rafraîchissement Tref.

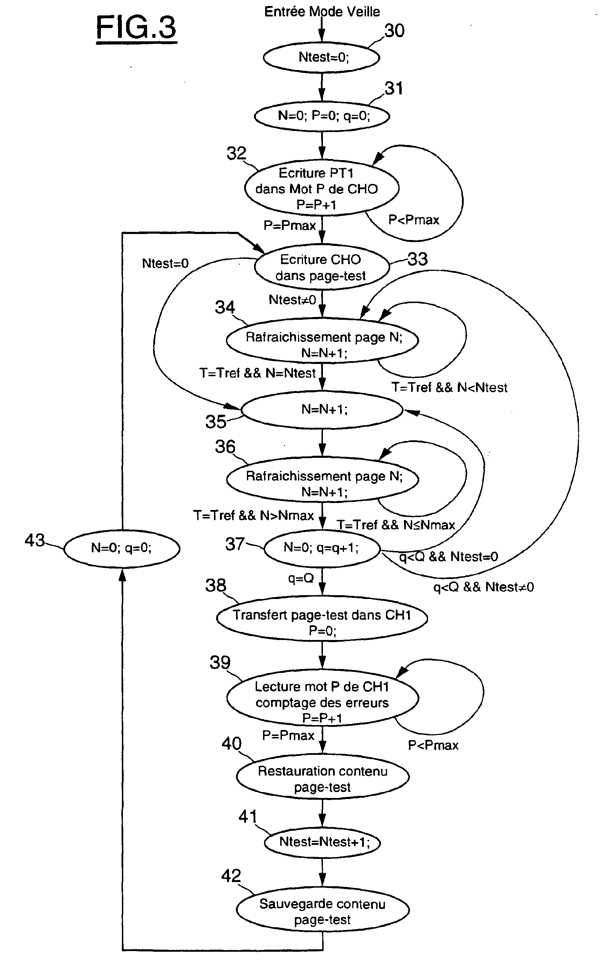

Pour décrire les différents états de cette machine FSM, on se réfère maintenant plus particulièrement à la figure 3.

Sur cette figure, et dans cet exemple de mise en oeuvre, N désigne l'adresse de page-mémoire, P désigne l'adresse d'un mot dans une page et Q désigne le nombre de cycles de rafraîchissement entre l'écriture du contenu de test dans une page de test et la lecture du contenu de cette page de test en vue de la comptabilisation des erreurs. Q est par exemple égal à 2.

Par ailleurs, le diagramme de la figure 3 correspond, pour des raisons de simplification, au cas où le nombre de pages de test est égal à 1. Et, Ntest désigne l'adresse de la page de test courante.

Enfin, T désigne le temps courant, compté en nombre de cycles, depuis le dernier rafraîchissement.

On suppose également, dans ce mode de mise en oeuvre, que la première page de la mémoire ne contient pas de donnée utile. On verra par conséquent que c'est dans cette première page que sera sauvegardé le contenu des pages ultérieures avant leur test.

A l'entrée dans le mode veille, la première page de la mémoire est utilisée comme page de test (Ntest égal zéro ; étape 30).

Les variables N, P et q sont initialisées également à zéro (étape 31).

Comme indiqué ci-avant, la période de rafraîchissement Tref est mise à la valeur minimale, correspondant à la température maximale d'utilisation du système.

Lorsque P est égal à Pmax, c'est-à-dire lorsque tous les mots de test ont été écrits dans la mémoire-tampon CH0, on transfère (étape 33) le contenu de la mémoire-tampon CH0 dans la page test de la mémoire MMV.

Comme Ntest est égal à zéro, on passe directement à l'étape 35, dans laquelle on incrémente N d'une unité puis on procède, dans l'étape 36, au rafraîchissement périodique de toutes les autre pages de la mémoire vive.

On réinitialise ensuite dans l'étape 37, N à zéro et on incrémente q.

Puisque q est inférieur à Q (pris égal ici par exemple à 2), on revient dans l'étape 35 et l'on procède à un deuxième rafraîchissement des pages de la mémoire autres que la page de test.

Lorsque q est égal à Q, on procède alors au "rafraîchissement" des cellules de test de la page de test. En fait, on utilise ici abusivement le terme "rafraîchissement" pour une cellule de test bien qu'il ne s'agisse pas en réalité d'un rafraîchissement. Plus précisément, on lit dans l'étape 38 le contenu des cellules de test que l'on stocke dans la mémoire-tampon CH1 puis on lit dans l'étape 39 le contenu de la mémoire-tampon CH1.

On procède alors au comptage des erreurs de lecture, en comparant le contenu ainsi lu avec le contenu de test PT1.

Ainsi, l'homme du métier aura remarqué que l'on "rafraîchit" les cellules de test Q fois moins souvent que les autres cellules de la mémoire vive.

Le fait d'utiliser deux mémoires-tampons permet encore de diminuer la consommation de courant puisqu'on charge le contenu de test dans l'une des mémoires-tampons, l'autre mémoire-tampon étant utilisée pour la lecture. Et, le rechargement périodique du contenu de test PT1 se fait alors en une seule opération dite de "write back" de la mémoire-tampon dans la page, au lieu de devoir réécrire systématiquement tous les mots de la page.

On procède ensuite à une restauration du contenu de la page test. En fait, cette étape 40 est non nécessaire dans le cas présent pour la première page de test, mais on verra qu'elle sera nécessaire pour les pages test suivantes.

Puis on incrémente Ntest d'une unité (étape 41) de façon que la page ayant l'adresse 1 dans la mémoire devienne à son tour la page test.

On procède alors à une sauvegarde (étape 41) du contenu de la nouvelle page test, par exemple ici en transférant son contenu dans la page d'adresse zéro.

Puis, après avoir réinitialisé à zéro les variables N et q (étape 43) on revient à l'étape 33 dans laquelle on charge la nouvelle page de test avec le contenu de test PT1.

Pour une page de test ayant l'adresse Ntest différente de zéro, on effectue successivement les étapes 34, 35, 36 et 37 au cours desquelles on procède à un rafraîchissement des pages de la mémoire autres que la page de test.

Puis, puisque Q est supérieur ou égal à 1, on effectue à nouveau un ou plusieurs rafraîchissements de la mémoire (en fonction du nombre Q) à l'exception de la page de test.

Puis, à l'issue de ces rafraîchissements, et après avoir effectué le transfert 38 du contenu de la page de test dans la mémoire-tampon CH1, on procède de nouveau au comptage des erreurs liées à la lecture de cette page de test.

Par ailleurs, on accumule ce nouveau nombre d'erreurs au nombre d'erreurs précédent correspondant à la page test précédente.

Puis, dans l'étape 40, on procède à la restauration du contenu de la page test, c'est-à-dire que l'on va réécrire dans la page-mémoire qui vient d'être la page test, le contenu initial qui a été sauvegardé dans le cas présent dans la page-mémoire d'adresse 0.

On peut alors de nouveau changer de page test et le cycle est répété jusqu'à ce que toutes les pages de la mémoire aient été utilisées comme page de test.

A ce moment-là, en fonction du nombre total d'erreurs accumulées, on augmente ou on diminue la période de rafraîchissement.

Ceci marque donc la fin d'un cycle principal de régulation de la période de rafraîchissement.

Puis c'est de nouveau la première page de la mémoire qui devient la page de test et les opérations décrites précédemment sont à nouveau effectuées successivement pour toutes les pages de la mémoire de façon à réaliser un nouveau cycle de régulation de la période de rafraîchissement.

En variante, la modification de la période de rafraîchissement peut également se faire dès qu'un certain nombre d'erreurs a été détecté, sans attendre la fin du test de l'ensemble de la mémoire si l'on veut pouvoir réagir plus rapidement à une variation de température par exemple.

Si l'on ne souhaite pas mettre de contrainte sur l'utilisation de certaines pages de la mémoire, il est possible d'utiliser une petite mémoire externe pour sauvegarder temporairement les données des pages testées. Bien entendu, cette mémoire doit alors contenir autant de pages que l'on teste en un cycle de fonctionnement de l'algorithme.

Dans le cas où l'on n'utilise qu'une seule page de test, il est alors particulièrement avantageux et particulièrement simple d'utiliser l'une des mémoires-tampons CH0 ou CH1 pour la sauvegarde temporaire des données de la page testée.

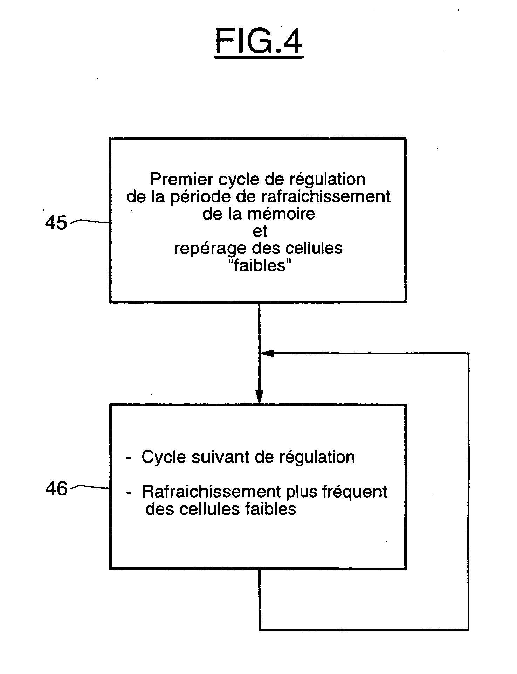

La variante de l'invention illustrée schématiquement sur la figure 4 permet de réduire la fréquence de rafraîchissement, et donc la consommation en mode de veille, même à température maximum de fonctionnement.

Le principe de cette variante consiste à repérer, au cours du premier cycle de régulation de la période de rafraîchissement de la mémoire, les pages ayant la moins grande rétention, de les noter comme "faibles" (étape 45) et de les rafraîchir ensuite plus souvent que le autres (étape 46).

En effet, généralement, plus de 90 % des pages de la mémoire peuvent être rafraîchies 2 à 4 fois moins souvent que ne le nécessitent les cellules de rétention minimum.

Plusieurs modes de mise en oeuvre de cette variante sont possibles.

Plus précisément, en ce qui concerne le séquencement, on peut concevoir de rafraîchir toutes les pages à la fréquence maximale, et de sauter le rafraîchissement des pages non notées "faibles" une fois sur deux.

Ou bien, le système peut travailler à la fréquence minimale plus 10 % et insérer un rafraîchissement supplémentaire de la page "faible" d'adresse n juste avant (ou après) de traiter la page d'adresse (N/2+n) modulo N, où N désigne le nombre de pages total dans la mémoire.

En ce qui concerne la mémorisation de l'information de page dite "faible", on peut utiliser par exemple une mémoire vive statique (mémoire SRAM) de N mots. Chaque mot permet alors de noter si la page est faible ou non et éventuellement l'état de son rafraîchissement si l'on opte pour la première solution de séquencement évoquée ci-dessus.

Il est également possible d'utiliser une mémoire associative de P mots avec P égal sensiblement à 10 % de N, cette mémoire stockant, pour chaque page d'adresse n notée "faible", la valeur (N/2+n) modulo N. Quand le compteur d'adresses de rafraîchissement arrive à l'une des adresses présentes dans la mémoire associative, il insère alors un rafraîchissement de la page d'adresse n.

Le choix de ces deux modes de mémorisation dépend du nombre de pages "faibles" considéré. Si ce nombre est faible, la deuxième solution qui vient d'être décrite est plus économique.

En ce qui concerne l'algorithme de décision, on peut par exemple rafraîchir la mémoire à la fréquence F et tester chaque page à la fréquence F/2. Lorsqu'une erreur est détectée, et s'il y a moins de N pages "faibles" la page pour laquelle une erreur est détectée est notée "faible" et sera rafraîchie à 2F et testée à F.

Si par contre il y a déjà N pages faibles, on ne note pas cette page comme faible mais on augmente la fréquence F.

Si, lorsque toutes les pages ont été testées, il n'y a eu aucune erreur, on diminue F et on recommence le test de la mémoire.

## Revendications

1. Procédé de rafraîchissement d'une mémoire vive dynamique, dans lequel on mesure continuellement et dynamiquement le temps de rétention de toutes les cellules-mémoire de la mémoire (MMV), et on utilise le résultat de cette mesure pour réguler la période de rafraîchissement de la mémoire, , **caractérisé par le fait que** la mesure continuelle et dynamique du temps de rétention de toutes les cellules comporte des sélections successives de groupes différents de cellules de la mémoire (MMV), dites cellules de test, de façon à balayer l'ensemble des cellules de la mémoire, des mesures élémentaires successives des temps de rétention de chaque group de cellules de test sélectionnées, et des rafraîchissements successifs (34-37) des cellules non sélectionnées, et **par le fait que** lesdites mesures élémentaires successives sont effectuées à une fréquence de mesure plus faible que la fréquence de rafraîchissement des autres cellules de la mémoire, de façon à rafraîchir les groupes de cellules de test plus lentement que les autres cellules de la mémoire.

2. Procédé selon la revendication 1, **caractérisé par le fait que** la mémoire est organisée par pages, et **par le fait que** chaque groupe de cellules de test est un nombre entier de pages.

3. Procédé selon la revendication 1 ou 2, **caractérisé par le fait qu'** une phase de mesure élémentaire comporte une écriture dans ces cellules de test sélectionnées d'un contenu de test prédéterminé (PT1) correspondant au changement de tous les condensateurs des cellules de test, puis une lecture des cellules de test et une comptabilisation du nombre d'erreurs en lecture du contenu des cellules de test compte tenu dudit contenu de test, **par le fait que** la mesure du temps de rétention de toutes les cellules comporte une accumulation au moins partielle des nombres successifs d'erreurs, et **par le fait qu'**entre l'écriture du contenu de test dans les cellules de test et la lecture de ces cellules de test, on effectue au moins deux rafraîchissements des autres cellules de la mémoire.

4. Procédé selon la revendication 3, **caractérisé par le fait que** la phase de mesure élémentaire comporte en outre pour certains au moins des groupes de cellules de test sélectionnées, une sauvegarde du contenu de ces cellules de test, et une restauration du contenu des cellules de test avec le contenu sauvegardé une fois la comptabilisation du nombre d'erreurs (NBE) effectuée.

5. Procédé selon la revendication 3 ou 4 **caractérisé par le fait que** la mémoire est équipée de deux mémoires-tampons (CH0, CH1) et **par le fait que** la phase de mesure élémentaire comporte une écriture du contenu de test dans une première mémoire-tampon (CH0) avant écriture dans les cellules de test, et **par le fait que** la lecture du contenu des cellules de test comporte une écriture du contenu de ces cellules de test dans la deuxième mémoire tampon (CH1) puis une lecture de la deuxième mémoire tampon.

6. Procédé selon la revendication 4 ou 5, **caractérisé par le fait qu'**on effectue la sauvegarde dans une partie prédéterminée de la mémoire ou bien dans une mémoire de sauvegarde externe.

7. Procédé selon les revendications 2 et 6, **caractérisé par le fait que** chaque cellule groupe de cellules de test forme une seule page de la mémoire, et **par le fait que** la mémoire de sauvegarde externe est l'une des mémoires-tampons.

8. Procédé selon l'une des revendications 3 à 7, **caractérisé par le fait que** la régulation de la période de rafraîchissement de la mémoire comporte une comparaison du nombre d'erreurs accumulées avec un seuil bas (SB1) et un seuil haut (SH1), une augmentation de la période de rafraîchissement si le nombre d'erreurs est inférieur au seuil bas, une diminution de la période de rafraîchissement si le nombre d'erreurs est supérieur au seuil haut, et une non-modification de la période de rafraîchissement si le nombre d'erreurs est supérieur ou égal au seuil bas et inférieur ou égal au seuil haut.

9. Procédé selon l'une des revendications 3 à 7, **caractérisé par le fait que** la régulation de la période de rafraîchissement de la mémoire comporte une comparaison du nombre d'erreurs accumulées avec un seuil unique une augmentation de la période de rafraîchissement si le nombre d'erreurs est inférieur au seuil unique et une diminution de la période de rafraîchissement si le nombre d'erreurs est supérieur ou égal au seuil unique.

10. Procédé selon l'une des revendications précédentes, **caractérisé par le fait qu'**on prévoit une valeur limite minimale (SB2) et une valeur limite maximale (SH2) pour la période de rafraîchissement.

11. Procédé selon l'une des revendications précédentes, **caractérisé par le fait que** la mesure du temps de rétention de toutes les cellules de la mémoire est effectué cycliquement, **par le fait qu'**au cours d'un cycle de mesure (45) on repère les cellules de la mémoire ayant une rétention plus faible, et **par le fait qu'**au cours du ou des cycles suivants (46) on rafraîchit ces cellules dites faibles plus souvent que les autres cellules de la mémoire.

12. Procédé selon l'une des revendications précédentes, **caractérisé par le fait que** la mémoire étant incorporée dans un appareil (TP) possédant un mode de veille et un mode de fonctionnement actif, on mesure le temps de rétention de toutes les cellules de la mémoire et on régule la période de rafraîchissement au moins au cours du mode de veille.

13. Procédé selon la revendication 12, **caractérisé par le fait que** ledit appareil est un composant d'un système de communication sans fil, par exemple un téléphone mobile cellulaire.

14. Dispositif de mémoire vive dynamique, comprenant une mémoire vive dynamique, des moyens de rafraîchissement de la mémoire, des moyens auxiliaires de traitement (MAT) aptes à mesurer continuellement et dynamiquement le temps de rétention de toutes les cellules-mémoire de la mémoire, et à utiliser le résultat de cette mesure pour réguler la période de rafraîchissement de la mémoire, **caractérisé par le fait que** les moyens auxiliaires de traitement (MAT) comportent des moyens de sélection aptes à effectuer des sélections successives de groupes différents de cellules de la mémoire, dites cellules de test, de façonna à balayer l'ensemble des cellules de la mémoire, et des moyens de mesure (RGT,ACC) aptes à effectuer des mesures élémentaires successives des temps de rétention de chaque groupe de cellules de test sélectionnées, **par le fait que** les moyens de rafraîchissement sont aptes à effectuer des rafraîchissements successifs des cellules non sélectionnées, et **par le fait que** les moyens auxiliaires de traitement comportent des moyens de commande (FSM) aptes à activer les moyens de mesure moins souvent que les moyens de rafraîchissement, de façon à rafraîchir les groupes de cellules de test plus lentement que les autres cellules de la mémoire.

15. Dispositif selon la revendication 14, **caractérisé par le fait que** la mémoire est organisée par pages, et **par le fait que** chaque groupe de cellules de test est un nombre entier de pages.

16. Dispositif selon la revendication 14 ou 15, **caractérisé par le fait que** les moyens de mesure comportent des moyens de stockage (RGT) aptes à stocker un contenu de test prédéterminé (PT1) correspondant au chargement de tous les condensateurs des cellules de test, des moyens d'écriture aptes à écrire le contenu de test dans les cellules de test sélectionnées, des moyens de lecture aptes à lire le contenu des cellules de test, des moyens de comptabilisation aptes à comptabiliser le nombre d'erreurs en lecture du contenu des cellules de test compte tenu dudit contenu de test, des moyens d'accumulation (ACC) aptes à effectuer une accumulation au moins partielle des nombres successifs d'erreurs, et **par le fait qu'**entre l'écriture du contenu de test dans les cellules de test et la lecture de ces cellules de test, les moyens de commande sont aptes à activer les moyens de rafraîchissement au moins deux fois.

17. Dispositif selon la revendication 16, **caractérisé par le fait que** les moyens de mesure comportent en outre des moyens de sauvegarde aptes à effectuer une sauvegarde du contenu des cellules de test, et des moyens de restauration aptes à effectuer une restauration du contenu des cellules de test avec le contenu sauvegardé une fois la comptabilisation du nombre d'erreurs effectuées, et **par le fait que** les moyens de commande sont aptes à activer les moyens de sauvegarde et de restauration pour certains au moins des groupes de cellules de test sélectionnées.

18. Dispositif selon la revendication 16 ou 17, **caractérisé par le fait qu'**il comporte deux mémoires-tampons (CH0, CH1) connectées à la mémoire vive dynamique, et **par le fait que** les moyens d'écriture sont aptes à écrire le contenu de test dans une première mémoire-tampon avant écriture dans les cellules de test, et **par le fait que** les moyens de lecture sont aptes à écrire le contenu des cellules de test dans la deuxième mémoire tampon puis à lire la deuxième mémoire-tampon.

19. Dispositif selon la revendication 17 ou 18, **caractérisé par le fait que** les moyens de sauvegarde sont aptes à effectuer la sauvegarde dans une partie prédéterminée de la mémoire ou bien dans une mémoire de sauvegarde externe.

20. Dispositif selon les revendications 15 et 19, **caractérisé par le fait que** chaque groupe de cellules de test forme une seule page de la mémoire, et **par le fait que** la mémoire de sauvegarde externe est l'une des mémoires-tampons.

21. Dispositif selon l'une des revendications 16 à 20, **caractérisé par le fait que** les moyens auxiliaires de traitement (MAT) comportent des moyens de comparaison aptes à effectuer une comparaison du nombre d'erreurs accumulées (NBE) avec un seuil bas et un seuil haut, et des moyens de régulation aptes à augmenter la période de rafraîchissement si le nombre d'erreurs est inférieur au seuil bas, à diminuer la période de rafraîchissement si le nombre d'erreurs est supérieur au seuil haut, et laisser la période de rafraîchissement inchangée si le nombre d'erreurs est supérieur ou égal au seuil bas et inférieur ou égal au seuil haut.

22. Dispositif selon l'une des revendications 16 à 20, **caractérisé par le fait que** les moyens auxiliaires de traitement (MAT) comportent des moyens de comparaison aptes à effectuer une comparaison du nombre d'erreurs accumulées (NBE) avec un seuil unique, et des moyens de régulation aptes à augmenter la période de rafraîchissement si le nombre d'erreurs est inférieur au seuil unique et à diminuer de la période de rafraîchissement si le nombre d'erreurs est supérieur ou égal au seuil unique.

23. Dispositif selon l'une des revendications 14 à 22, **caractérisé par le fait qu'**il comporte des moyens de stockage supplémentaires, par exemple des registres, stockant une valeur limite minimale (SB2) et une valeur limite maximale (SH2) pour la période de rafraîchissement.

24. Dispositif selon l'une des revendications 14 à 23, **caractérisé par le fait que** les moyens auxiliaires de traitement sont aptes à effectuer cycliquement la mesure du temps de rétention de toutes les cellules de la mémoire, **par le fait qu'**au cours d'un cycle de mesure, les moyens auxiliaires de traitement (MAT) sont aptes à repérer les cellules de la mémoire ayant une rétention plus faible, et **par le fait qu'**au cours du ou des cycles suivants les moyens de rafraîchissement sont aptes à rafraîchir ces cellules dites faibles plus souvent que les autres cellules de la mémoire.

25. Appareil possédant un mode de veille et un mode de fonctionnement actif, **caractérisé par le fait qu'**il incorpore un dispositif selon l'une des revendications 14 à 25, et **par le fait que** les moyens auxiliaires de traitement sont aptes à mesurer le temps de rétention de toutes les cellules de la mémoire et à réguler la période de rafraîchissement, au moins au cours du mode de veille.

26. Appareil selon la revendication 25, **caractérisé par le fait qu'**il constitue un composant d'un système de communication sans fil.

27. Appareil selon la revendication 26,**caractérisé par le fait qu'**il forme un téléphone mobile cellulaire.

## Claims

1. Process for refreshing a dynamic random access memory in which the retention time of all the memory cells of the memory (MMV) is measured continuously and dynamically, and the result of this measurement is used to regulate the refresh period of the memory, **characterized in that** the continuous and dynamic measurement of the retention time of all the cells comprises successive selections of different groups of cells of the memory (MMV), the so-called test cells, in such a way as to scan the entire set of cells of the memory, successive elementary measurements of the retention times of each group of selected test cells, and successive refreshings (34-37) of the unselected cells, and **in that** the said successive elementary measurements are performed at a lower measurement frequency than the refresh frequency of the other cells of the memory, in such a way as to refresh the groups of test cells more slowly than the other cells of the memory.

2. Process according to Claim 1, **characterized in that** the memory is organized by pages, and **in that** each group of test cells is an integer number of pages.

3. Process according to Claim 1 or 2, **characterized in that** an elementary measurement phase comprises a writing to these selected test cells of a predetermined test content (PT1) corresponding to the charging of all the capacitors of the test cells, then a reading of the test cells and a metering of the number of errors in reading the content of the test cells having regard to the said test content, **in that** the measurement of the retention time of all the cells comprises an at least partial accumulation of the successive numbers of errors, and **in that** between the writing of the test content to the test cells and the reading of these test cells, at least two refreshings of the other cells of the memory are performed.

4. Process according to Claim 3, **characterized in that** the elementary measurement phase furthermore comprises, for certain at least of the groups of selected test cells, a backup of the content of these test cells, and a restoring of the content of the test cells with the backed up content once the metering of the number of errors (NBE) has been performed.

5. Process according to Claim 3 or 4, **characterized in that** the memory is equipped with two buffer memories (CH0, CH1) and **in that** the elementary measurement phase comprises a writing of the test content into a first buffer memory (CH0) before writing to the test cells, and **in that** the reading of the content of the test cells comprises a writing of the content of these test cells into the second buffer memory (CH1) and then a reading of the second buffer memory.

6. Process according to Claim 4 or 5, **characterized in that** the backup is performed in a predetermined part of the memory or else in an external backup memory.

7. Process according to Claims 2 and 6, **characterized in that** each group of test cells forms a single page of the memory, and **in that** the external backup memory is one of the buffer memories.

8. Process according to one of Claims 3 to 7, **characterized in that** the regulating of the refresh period of the memory comprises a comparison of the number of accumulated errors with a low threshold (SB1) and a high threshold (SH1), an increasing of the refresh period if the number of errors is less than the low threshold, a decreasing of the refresh period if the number of errors is greater than the high threshold, and a non-modification of the refresh period if the number of errors is greater than or equal to the low threshold and less than or equal to the high threshold.

9. Process according to one of Claims 3 to 7, **characterized in that** the regulating of the refresh period of the memory comprises a comparison of the number of accumulated errors with a single threshold, an increasing of the refresh period if the number of errors is less than the single threshold and a decreasing of the refresh period if the number of errors is greater than or equal to the single threshold.

10. Process according to one of the preceding claims, **characterized in that** there are provided a minimum limit value (SB2) and a maximum limit value (SH2) for the refresh period.

11. Process according to one of the preceding claims, **characterized in that** the measurement of the retention time of all the cells of the memory is performed cyclically, **in that** in the course of a measurement cycle (45), the cells of the memory having a lower retention are tagged, and **in that** in the course of the next cycle or cycles (46), these so-called low cells are refreshed more often than the other cells of the memory.

12. Process according to one of the preceding claims, **characterized in that**, the memory being incorporated into an apparatus (TP) possessing a standby mode and an active mode of operation, the retention time of all the cells of the memory is measured and the refresh period is regulated, at least in the course of the standby mode.

13. Process according to Claim 12, **characterized in that** the said apparatus is a component of a wireless communication system, for example a cellular mobile telephone.

14. Dynamic random access memory device, comprising a dynamic random access memory, means for refreshing the memory, auxiliary processing means (MAT) able to continuously and dynamically measure the retention time of all the memory cells of the memory, and to use the result of this measurement to regulate the refresh period of the memory, **characterized in that** the auxiliary processing means (MAT) comprise selection means able to perform successive selections of different groups of cells of the memory, the so-called test cells, in such a way as to scan the entire set of cells of the memory, and measurement means (RGT, ACC) able to perform successive elementary measurements of the retention times of each group of selected test cells, **in that** the refresh means are able to perform successive refreshings of the unselected cells, and **in that** the auxiliary processing means comprise control means (FSM) able to activate the measurement means less often than the refresh means, in such a way as to refresh the groups of test cells more slowly than the other cells of the memory.

15. Device according to Claim 14, **characterized in that** the memory is organized by pages, and **in that** each group of test cells is an integer number of pages.

16. Device according to Claim 14 or 15, **characterized in that** the measurement means comprise storage means (RGT) able to store a predetermined test content (PT1) corresponding to the charging of all the capacitors of the test cells, writing means able to write the test content into the selected test cells, reading means able to read the content of the test cells, metering means able to meter the number of errors in reading the content of the test cells having regard to the said test content, accumulation means (ACC) able to perform an at least partial accumulation of the successive numbers of errors, and **in that** between the writing of the test content to the test cells and the reading of these test cells, the control means are able to activate the refresh means at least twice.

17. Device according to Claim 16, **characterized in that** the measurement means furthermore comprise backup means able to perform a backup of the content of the test cells, and restoration means able to perform a restoration of the content of the test cells with the backed up content once the metering of the number of errors has been performed, and **in that** the control means are able to activate the backup and restoration means for certain at least of the groups of selected test cells.

18. Device according to Claim 16 or 17, **characterized in that** it comprises two buffer memories (CH0, CH1) connected to the dynamic random access memory, and **in that** the writing means are able to write the test content into a first buffer memory before writing to the test cells, and **in that** the reading means are able to write the content of the test cells into the second buffer memory and then to read the second buffer memory.

19. Device according to Claim 17 or 18, **characterized in that** the backup means are able to perform the backup in a predetermined part of the memory or else in an external backup memory.

20. Device according to Claims 15 and 19, **characterized in that** each group of test cells forms a single page of the memory, and **in that** the external backup memory is one of the buffer memories.

21. Device according to one of Claims 16 to 20, **characterized in that** the auxiliary processing means (MAT) comprise comparison means able to perform a comparison of the number of accumulated errors (NBE) with a low threshold and a high threshold, and regulating means able to increase the refresh period if the number of errors is less than the low threshold, to decrease the refresh period if the number of errors is greater than the high threshold, and leave the refresh period unchanged if the number of errors is greater than or equal to the low threshold and less than or equal to the high threshold.

22. Device according to one of Claims 16 to 20, **characterized in that** the auxiliary processing means (MAT) comprise comparison means able to perform a comparison of the number of accumulated errors (NBE) with a single threshold, and regulating means able to increase the refresh period if the number of errors is less than the single threshold and to decrease the refresh period if the number of errors is greater than or equal to the single threshold.

23. Device according to one of Claims 14 to 22, **characterized in that** it comprises additional storage means, for example registers, storing a minimum limit value (SB2) and a maximum limit value (SH2) for the refresh period.

24. Device according to one of Claims 14 to 23, **characterized in that** the auxiliary processing means are able to cyclically perform the measurement of the retention time of all the cells of the memory, **in that** in the course of a measurement cycle, the auxiliary processing means (MAT) are able to tag the cells of the memory having a lower retention, and **in that** in the course of the next cycle or cycles, the refresh means are able to refresh these so-called low cells more often than the other cells of the memory.

25. Apparatus possessing a standby mode and an active mode of operation, **characterized in that** it incorporates a device according to one of Claims 14 to 25, and **in that** the auxiliary processing means are able to measure the retention time of all the cells of the memory and regulate the refresh period, at least in the course of the standby mode.

26. Apparatus according to Claim 25, **characterized in that** it constitutes a component of a wireless communication system.

27. Apparatus according to Claim 26, **characterized in that** it forms a cellular mobile telephone.

## Patentansprüche

1. Verfahren zum Auffrischen eines DRAM-Speichers, wobei die Haltezeit aller Speicherzellen des Speichers (MMV) kontinuierlich und dynamisch gemessen wird und das Ergebnis dieser Messung verwendet wird, um die Auffrischungsperiode des Speichers zu regeln,
**dadurch gekennzeichnet, daß** die kontinuierliche und dynamische Messung der Haltezeit aller Zellen aufweist:
aufeinanderfolgendes Auswählen verschiedener Zellengruppen des Speichers (MMV), sogenannter Testzellen, derart, daß die Gesamtheit der Zellen des Speichers abgetastet wird,
aufeinanderfolgende elementare Messungen der Haltezeiten jeder Gruppe von ausgewählten Testzellen und
aufeinanderfolgendes Auffrischen (34-37) der nicht ausgewählten Zellen,
und dadurch, daß die aufeinanderfolgenden elementaren Messungen in einer Meßfrequenz durchgeführt werden, die kleiner ist als die Auffrischungsfrequenz der anderen Zellen des Speichers, so daß die Testzellengruppen langsamer aufgefrischt werden als die anderen Zellen des Speichers.

2. Verfahren nach Anspruch 1, **dadurch gekennzeichnet, daß** der Speicher in Seiten organisiert ist, und dadurch, daß jede Gruppe von Testzellen eine ganze Zahl von Seiten ist.

3. Verfahren nach Anspruch 1 oder 2, **dadurch gekennzeichnet, daß** eine elementare Meßphase ein Schreiben eines vorgegebenen Testinhalts (PT1), der der Ladung aller Kondensatoren der Testzellen entspricht, in diese ausgewählten Testzellen aufweist, dann ein Lesen der Testzellen und eine Verbuchung der Anzahl von Fehlern (Fehlerzahl) beim Lesen des Inhalts der Testzellen unter Berücksichtigung des Testinhalts,
dadurch, daß die Messung der Haltezeit aller Zellen eine zumindest teilweise Kumulation der aufeinanderfolgenden Fehlerzahlen aufweist,
und dadurch, daß zwischen dem Schreiben des Testinhalts in die Testzellen und dem Lesen dieser Testzellen mindestens zwei Auffrischungen der anderen Zellen des Speichers durchgeführt werden.

4. Verfahren nach Anspruch 3, **dadurch gekennzeichnet, daß** zumindest für einige der ausgewählten Testzellengruppen die elementare Meßphase ferner eine Sicherung des Inhalts dieser Testzellen und eine Wiederherstellung des Inhalts der Testzellen mit dem gesicherten Inhalt, nachdem die Verbuchung der Fehlerzahl (NBE) durchgeführt worden ist, aufweist.

5. Verfahren nach Anspruch 3 oder 4, **dadurch gekennzeichnet, daß** der Speicher mit zwei Pufferspeichern (CH0, CH1) ausgestattet ist, und dadurch, daß die elementare Meßphase ein dem Schreiben in die Testzellen vorausgehendes Schreiben des Testinhalts in einen ersten Pufferspeicher (CH0) aufweist, und dadurch, daß das Lesen des Inhalts der Testzellen ein Schreiben des Inhalts dieser Testzellen in den zweiten Pufferspeicher (CH1), dann ein Lesen des zweiten Pufferspeichers aufweist.

6. Verfahren nach Anspruch 4 oder 5, **dadurch gekennzeichnet, daß** die Sicherung in einen vorgegebenen Teil des Speichers oder auch in einen externen Sicherungsspeicher erfolgt.

7. Verfahren nach Anspruch 2 und 6, **dadurch gekennzeichnet, daß** jede Testzellengruppe eine einzelne Seite des Speichers bildet, und dadurch, daß der externe Sicherungsspeicher einer der Pufferspeicher ist.

8. Verfahren nach einem der Ansprüche 3 bis 7, **dadurch gekennzeichnet, daß** die Regelung der Auffrischungsperiode des Speichers aufweist:
einen Vergleich der kumulierten Fehlerzahl mit einer unteren Schwelle (SB1) und einer oberen Schwelle (SH1),
eine Erhöhung der Auffrischungsperiode, wenn die Fehlerzahl kleiner als die untere Schwelle ist,
eine Verringerung der Auffrischungsperiode, wenn die Fehlerzahl größer als die obere Schwelle ist, und
eine Beibehaltung der Auffrischungsperiode, wenn die Fehlerzahl größer oder gleich der unteren Schwelle oder kleiner oder gleich der oberen Schwelle ist.

9. Verfahren nach einem der Ansprüche 3 bis 7, **dadurch gekennzeichnet, daß** die Regelung der Auffrischungsperiode des Speichers aufweist:
einen Vergleich der kumulierten Fehlerzahl mit einer einzigen Schwelle,
eine Erhöhung der Auffrischungsperiode, wenn die Fehlerzahl kleiner als die einzige Schwelle ist, und
eine Verringerung der Auffrischungsperiode, wenn die Fehlerzahl größer oder gleich der einzigen Schwelle ist.

10. Verfahren nach einem der vorstehenden Ansprüche, **dadurch gekennzeichnet, daß** ein minimaler Grenzwert (SB2) und ein maximaler Grenzwert (SH2) für die Auffrischungsperiode vorgesehen sind.

11. Verfahren nach einem der vorstehenden Ansprüche,
**dadurch gekennzeichnet, daß** die Messung der Haltezeit aller Zellen des Speichers zyklisch durchgeführt wird,
dadurch, daß im Verlaufe eines Meßzyklus (45) die Zellen des Speichers, die ein schwächeres Halten haben, markiert werden, und
dadurch, daß im Verlaufe des oder der folgenden Zyklen (46) dieses sogenannten schwachen Zellen öfter aufgefrischt werden als die anderen Zellen des Speichers.

12. Verfahren nach einem der vorstehenden Ansprüche, **dadurch gekennzeichnet, daß** bei einem Speicher, der in einem Gerät (TP) eingebaut ist, das einen Bereitschaftsmodus und einen aktiven Betriebsmodus hat, die Haltezeit aller Zellen des Speichers gemessen wird und die Auffrischungsperiode zumindest während des Bereitschaftsmodus geregelt wird.

13. Verfahren nach Anspruch 12, **dadurch gekennzeichnet, daß** das Gerät eine Komponente eines Funkkommunikationssystems, beispielsweise ein zellulares Mobiltelefon, ist.

14. DRAM-Speichervorrichtung mit einem DRAM-Speicher, Einrichtungen zum Auffrischen des Speichers, Verarbeitungshilfseinrichtungen (MAT), die in der Lage sind, die Haltezeit aller Speicherzellen des Speichers kontinuierlich und dynamisch zu messen und das Ergebnis dieser Messung zu verwenden, um die Auffrischungsperiode des Speichers zu regeln,
**dadurch gekennzeichnet, daß** die Verarbeitungshilfseinrichtungen (MAT) aufweisen:
Auswahleinrichtungen, die in der Lage sind, aufeinanderfolgendes Auswählen verschiedener Zellengruppen des Speichers, sogenannter Testzellen, durchzuführen, derart, daß die Gesamtheit der Speicherzellen abgetastet wird, und
Meßeinrichtungen (RGT, ACE), die in der Lage sind, aufeinanderfolgende elementare Messungen der Haltezeiten jeder Gruppe von ausgewählten Testzellen durchzuführen,
dadurch, daß die Auffrischungseinrichtungen in der Lage sind, aufeinanderfolgende Auffrischungen der nicht ausgewählten Zellen durchzuführen, und
dadurch, daß die Verarbeitungshilfseinrichtungen Steuereinrichtungen (FSM) aufweisen, die in der Lage sind, die Meßeinrichtungen weniger oft als die Auffrischungseinrichtungen zu aktivieren, so daß die Gruppen von Testzellen langsamer aufgefrischt werden als die anderen Zellen des Speichers.

15. Vorrichtung nach Anspruch 14, **dadurch gekennzeichnet, daß** der Speicher in Seiten organisiert ist, und dadurch, daß jede Gruppe von Testzellen eine ganze Zahl von Seiten ist.

16. Vorrichtung nach Anspruch 14 oder 15, **dadurch gekennzeichnet, daß** die Meßeinrichtungen aufweisen:
Speichereinrichtungen (RGT), die in der Lage sind, einen vorgegebenen Testinhalt (PT1), der der Aufladung aller Kondensatoren der Testzellen entspricht, zu speichern,
Schreibeinrichtungen, die in der Lage sind, den Testinhalt in die ausgewählten Testzellen zu schreiben,
Leseeinrichtungen, die in der Lage sind, den Inhalt der Testzellen zu lesen,
Verbuchungseinrichtungen, die in der Lage sind, die Fehlerzahl beim Lesen des Inhalts der Testzellen unter Berücksichtigung des Testinhalts zu verbuchen,
Kumulationseinrichtungen (ACE), die in der Lage sind, eine zumindest teilweise Kumulation aufeinanderfolgender Fehlerzahlen durchzuführen, und
dadurch, daß zwischen dem Schreiben des Testinhalts in die Testzellen und dem Lesen dieser Testzellen die Steuereinrichtungen in der Lage sind, mindestens zwei Mal die Auffrischungseinrichtungen zu aktivieren.

17. Vorrichtung nach Anspruch 16, **dadurch gekennzeichnet, daß** die Meßeinrichtungen ferner aufweisen:
Sicherungseinrichtungen, die in der Lage sind, eine Sicherung des Inhalts der Testzellen durchzuführen, und
Wiederherstellungseinrichtungen, die in der Lage sind, eine Wiederherstellung des Inhalts der Testzellen mit dem gesicherten Inhalt durchzuführen, nachdem die Verbuchung der Fehlerzahlen durchgeführt worden ist, und
dadurch, daß die Steuereinrichtungen in der Lage sind, die Sicherungs- und Wiederherstellungseinrichtungen zumindest für einige der ausgewählten Testzellengruppen zu aktivieren.

18. Vorrichtung nach Anspruch 16 oder 17, **dadurch gekennzeichnet, daß** sie zwei mit dem DRAM-Speicher verbundene Pufferspeicher (CH0, CH1) aufweist, und dadurch, daß die Schreibeinrichtungen in der Lage sind, den Testinhalt, bevor er in die Testzellen geschrieben wird, in einen ersten Pufferspeicher zu schreiben, und dadurch, daß die Leseeinrichtungen in der Lage sind, den Inhalt der Testzellen in den zweiten Pufferspeicher zu schreiben, dann den zweiten Pufferspeicher zu lesen.

19. Vorrichtung nach Anspruch 17 oder 18, **dadurch gekennzeichnet, daß** die Sicherungseinrichtungen in der Lage sind, die Sicherung in einem vorgegebenen Teil des Speichers oder auch in einem externen Sicherungsspeicher durchzuführen.

20. Vorrichtung nach Anspruch 15 und 19, **dadurch gekennzeichnet, daß** jede Testzellengruppe eine einzelne Seite des Speichers bildet, und dadurch, daß der externe Sicherungsspeicher einer der Pufferspeicher ist.

21. Vorrichtung nach einem der Ansprüche 16 bis 20, **dadurch gekennzeichnet, daß** die Verarbeitungshilfseinrichtungen (MAT) aufweisen:
Vergleichseinrichtungen, die in der Lage sind, einen Vergleich der kumulierten Fehlerzahl (NBE) mit einer unteren Schwelle und einer oberen Schwelle durchzuführen, und
Regelungseinrichtungen, die in der Lage sind, die Auffrischungsperiode zu erhöhen, wenn die Fehlerzahl kleiner als die untere Schwelle ist, die Auffrischungsperiode zu verringern, wenn die Fehlerzahl größer als die obere Schwelle ist, und die Auffrischungsperiode unverändert zu lassen, wenn die Fehlerzahl größer oder gleich der unteren Schwelle oder kleiner oder gleich der oberen Schwelle ist.

22. Vorrichtung nach einem der Ansprüche 16 bis 20, **dadurch gekennzeichnet, daß** die Verarbeitungshilfseinrichtungen (MAT) aufweisen:
Vergleichseinrichtungen, die in der Lage sind, einen Vergleich der kumulierten Fehlerzahl (NBE) mit einer einzigen Schwelle durchzuführen, und
Regelungseinrichtungen, die in der Lage sind, die Auffrischungsperiode zu erhöhen, wenn die Fehlerzahl kleiner als die einzige Schwelle ist, und die Auffrischungsperiode zu verringern, wenn die Fehlerzahl größer oder gleich der einzigen Schwelle ist.

23. Vorrichtung nach einem der Ansprüche 14 bis 22, **dadurch gekennzeichnet, daß** sie zusätzliche Speichereinrichtungen, beispielsweise Register, aufweist, die einen minimalen Grenzwert (SB2) und einen maximalen Grenzwert (SH2) für die Auffrischungsperiode speichern.

24. Vorrichtung nach einem der Ansprüche 14 bis 23, **dadurch gekennzeichnet, daß** die Verarbeitungshilfseinrichtungen in der Lage sind, die Messung der Haltezeit aller Zellen des Speichers zyklisch durchzuführen, dadurch, daß im Verlaufe eines Meßzyklus die Verarbeitungshilfseinrichtungen (MAT) in der Lage sind, die Zellen des Speichers, die ein schwächeres Halten haben, zu markieren, und dadurch, daß im Verlaufe des oder der folgenden Zyklen die Auffrischungseinrichtungen in der Lage sind, dieses sogenannten schwachen Zellen öfter aufzufrischen als die anderen Zellen des Speichers.

25. Gerät, das einen Bereitschaftsmodus und einen aktiven Betriebsmodus hat, **dadurch gekennzeichnet, daß** es eine Vorrichtung nach einem der Ansprüche 14 bis 24 aufweist, und dadurch, daß die Verarbeitungshilfseinrichtungen in der Lage sind, die Haltezeit aller Zellen des Speichers zu messen und die Auffrischungsperiode zumindest während des Bereitschaftsmodus zu regeln.

26. Gerät nach Anspruch 25, **dadurch gekennzeichnet, daß** es eine Komponente eines Funkkommunikationssystems bildet.

27. Gerät nach Anspruch 26, **dadurch gekennzeichnet, daß** es ein zellulares Mobiltelefon bildet.
